# EUROPEAN PATENT APPLICATION

(11) **EP 4 808 299 A1**
(43) Date of publication of application: **16.09.2026**
(21) Application number: 24888142.7
(22) Date of filing: 08.11.2024
(51) Int. Cl.: H05K 7/20, F28D 1/02

(54) **COOLING SYSTEM FOR DATA PROCESSING DEVICES WITH HEAT RECOVERY TO GENERATE HOT WATER**

(30) Priority: 11.11.2023 ES 202332008 U
(71) Applicant: Therminer S.L., 42003 Soria (ES)
(72) Inventor: MOLINA GALÁN, Aarón, 42003 Soria (ES); GARÍA IRANZO, Gonzalo, 46013 VALENCIA (ES)
(74) Representative: Pons IP
(86) International application number: PCT/ES2024/070696
(87) International publication number: WO 2025/099348

(57) **Abstract**

The present invention relates to a cooling system for data processing devices with heat recovery to generate hot water that comprises a tank (1) with dielectric oil in which the data processor is submerged. The dielectric oil is a heat-carrying liquid coolant. The system may comprise a heat exchanger (11) that transfers the heat of the dielectric oil to a water circuit. The system may comprise a first 3-way valve that in a first position (12) directs the dielectric oil towards the heat exchanger or in a second position (13) directs the dielectric oil towards a second 3-way valve that in a first position (14) directs the dielectric oil towards the outside of the system through a first outlet (8) or in a second position (15) directs the dielectric oil towards a second outlet (9). The system may comprise a printed circuit board (PCB) and temperature sensors, which control and monitor correct operation.

## Description

### TECHNICAL FIELD

The object of this utility model application is to register a cooling system for data processing units with heat recovery for hot water generation.

Data processing units require cooling for their appropriate operation, which keeps the units at a suitable temperature and prevents it from overheating. Currently, air conditioning cooling systems, water cooling systems or FREE Cooling (cooling by outside air, taking advantage of the low temperatures of the Data Centre locations) are used. In all these cases, the energy extracted from the units in the form of heat is wasted and dissipated into the environment. Moreover, these cooling systems lead to a very significant increase in the electricity consumption of the Data Centre.

### BACKGROUND OF THE INVENTION

As we have mentioned, there are various cooling systems that represent a very significant increase in the electrical consumption of the Data Centre, making it inefficient in terms of energy.

*Power Usage Effectiveness*, or PUE, is a metric defined by The Green Grid to measure the energy efficiency of data centres. It is the main metric widely accepted by the industry, and provides the Data Centre operator with a quick estimate of their efficiency.

It is calculated as follows: PUE = Total electrical power of the centre / Total electrical power consumed by the systems, with a value that is always greater than or equal to 1. A value of 1.0 would indicate 100% efficiency (a theoretical value that cannot be achieved), and the closer we get to that value, the more efficient the data centre will be. Studies show that most data centres have PUE values close to 3.0. With the implementation of best practices and the optimisation of the infrastructure, it may be feasible to achieve values of up to 1.16.

There are 5 factors that affect the PUE: the climate, the level of electrical redundancy and air conditioning in the installation, the efficiency of the air conditioning system, the efficiency of the electrical system and UPS, and the occupancy and capacity of the Data Centre. Of all these factors, the element that has the greatest impact on the PUE is the efficiency of the air conditioning system.

### DESCRIPTION OF THE INVENTION

The present model solves two of the problems outlined. On the one hand, energy in the form of heat extracted from the cooling of the servers will be reused to generate hot water that can be used for industrial processes or district heating networks (recovering 90% of the electrical energy). On the other hand, the electrical consumption of the Data Centre's cooling system will be reduced (by up to 95%), making it more efficient and sustainable. All this will be achieved with an immersion cooling system which, in addition to solving said problems, will reduce maintenance costs and improve the service life of the server (increasing it by 30%), since its components will not be subject to temperature variations, reducing the potential for failures, and the fact that cooling fans are not required will eliminate the degradation of components due to vibration, and make it possible to increase the computational density (by 350%).

The cooling system assembly for data processing units with heat recovery for hot water generation comprises 2 subsystems, the plumbing subsystem and the control subsystem, and has a cover with an exterior finish of galvanised steel sheet.

The plumbing subsystem comprises a stainless steel tank, a dielectric oil circuit and a water circuit that share a heat exchanger.

The stainless steel tank is open at the top and the units are immersed therein in a dielectric oil, a fluid that will be heated by direct contact.

The function of the dielectric oil circuit is to circulate the hot oil from the tank to the heat exchanger inside the system or to an external medium where that heat is extracted, and to return same cold to the tank again.

The water circuit will circulate the cold water from the system water inlet to the system water outlet (hot water) through the heat exchanger (where it absorbs the heat released by the dielectric oil).

The control part comprises a PCB board that monitors the oil and water temperatures and the status of the units during their activity through sensors and coordinates the operation of the elements of the plumbing part.

### BRIEF DESCRIPTION OF THE DRAWINGS

To complement the description that is being made and in order to help make the features of the invention more readily understandable, a set of drawings is attached as an integral part of said description wherein, for illustrative and non-limiting purposes, the following has been represented:
Figure 1 shows an overall view of the device of the invention.
Figure 2a shows the tank of the device with the sleeve.
Figure 2b shows the equipment tank with the connections.
Figure 3 shows the connections of the device.
Figure 4 shows the heat exchanger.
Figure 5a shows the first 3-way valve in position 1.
Figure 5b shows the first 3-way valve in position 2.
Figure 6a shows the second 3-way valve in position 1.
Figure 6b shows the second 3-way valve in position 2.

### PREFERRED EMBODIMENT OF THE INVENTION

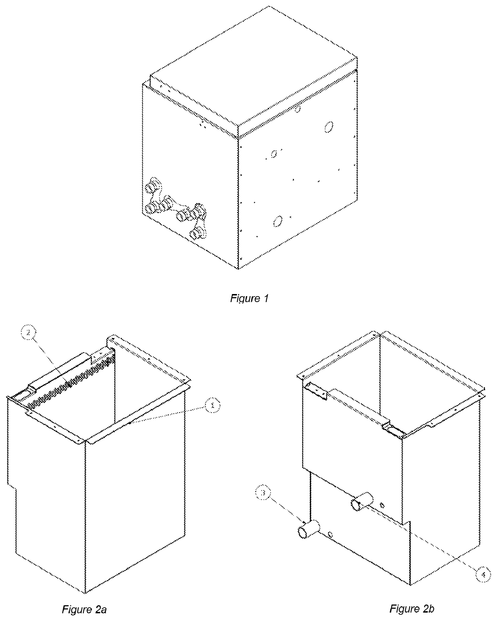

A particular example of the cooling system (Figure 1) according to the present invention is described below with reference to the attached figures.

The stainless steel tank (Figures 2a and 2b) is open at the top and the units are immersed therein in a dielectric oil. A sleeve (2) is housed in said tank (1) and is in communication with the tank through the upper portion. The oil heats up due to being in contact with the hardware components of the units, being stratified and leaving the hottest oil at the top of the tank, which then falls into the sleeve. The tank has an outlet (4) that connects the sleeve with the outside of the tank. The hot oil that leaves the tank will pass to the dielectric oil circuit and will return cold to the tank through the inlet located at the base of the tank (3).

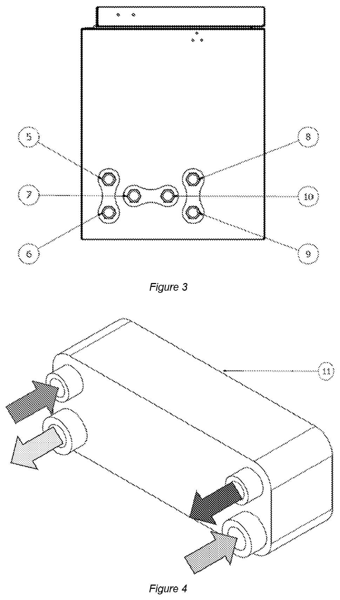

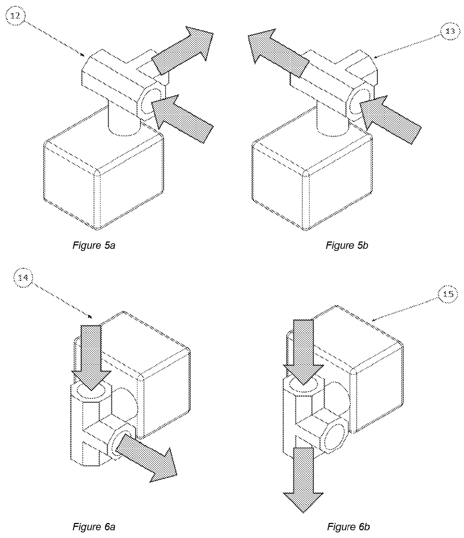

The dielectric oil circuit is divided into 2 parts; it can be said that it has an internal circuit and an external circuit. The internal circuit leads the oil from the tank outlet (4) to the tank inlet (3), being driven by a circulation pump passing through the first 3-way valve (in position 1) (Figure 5a) and through the heat exchanger (Figure 4), where it will release its heat and cool down. The external circuit also starts at the tank outlet (4), but when it reaches the first 3-way valve (in position 2) (Figure 5b) it is led to the second 3-way valve (in position 1) (Figure 6a), which leads it to an external outlet of the cooling system (8) or (in position 2) (Figure 6b) leads it to another external outlet of the system (9). The hot oil is used to heat water in an external system and returned to the cooling system through the oil inlet (5), which communicates with the aforementioned tank inlet (3). In addition, it has an outlet for emptying the dielectric oil circuit (6).

The water circuit is an external circuit of the cooling system since all the water inlets and outlets are external; it will take the cold water from the water inlet (7) to the outlet (10) (hot water) driven by a circulation pump passing through the heat exchanger (Figure 4) where it absorbs the heat released by the dielectric oil.

The system can be used both at the residential and industrial level. On a residential level, the hot water extracted would be used for district heating networks, and on an industrial level, use for heating and domestic hot water are also options; but said hot water can also be used for industrial processes directly or as a water preheating step, or to use the hot oil for producing hot water by means of an external system (for example, a heat pump).

## Claims

1. A cooling system for data processing devices with heat recovery to generate hot water, **characterised in that** it comprises a tank (1) with dielectric oil in which the data processor is submerged.

2. The cooling system, according to claim 1, **characterised by** the use of a liquid coolant as a heat-carrying fluid (dielectric oil).

3. The cooling system, **characterised by** the use of a heat exchanger (11) that transfers the heat of the dielectric oil to the water circuit.

4. The cooling system, **characterised by** the use of a first 3-way valve that in a position 1 (12) directs the dielectric oil towards the heat exchanger (11) or in position 2 (13) towards the second 3-way valve.

5. The cooling system, **characterised by** the use of a second 3-way valve which in position 1 (14) directs the dielectric oil out of the system through a first outlet (8) or in position 2 (15) towards a second outlet (9).

6. The cooling system, **characterised by** the use of a PCB board together with temperature sensors, which control and monitor correct operation of the system.
